**Europäisches Patentamt**

**European Patent Office**

**Office européen des brevets**

(11) Veröffentlichungsnummer: **0 229 915 B1**

# (12) EUROPÄISCHE PATENTSCHRIFT

(45) Veröffentlichungstag der Patentschrift:
**23.01.91 Patentblatt 91/04**

(21) Anmeldenummer: **86115906.9**

(22) Anmeldetag: **15.11.86**

(51) Int. Cl.⁵: **C04B 41/88, C04B 41/91, C23C 16/02, H05K 3/38**

(54) Verfahren zur haftfesten Metallisierung von keramischen Materialien.

(30) Priorität: **20.01.86 DE 3601834**

(43) Veröffentlichungstag der Anmeldung:
**29.07.87 Patentblatt 87/31**

(45) Bekanntmachung des Hinweises auf die Patenterteilung:
**23.01.91 Patentblatt 91/04**

(84) Benannte Vertragsstaaten:
**BE CH DE ES FR GB IT LI LU NL SE**

(56) Entgegenhaltungen:
**DE-A- 2 232 276
DE-A- 3 150 399
DE-A- 3 345 353
DE-A- 3 421 989
SPRECHSAAL, Nr. 18, 1974, Coburg W.
SCHILLER "Metallisierung von Keramik"
Seiten 771-773, 776, 777**

(73) Patentinhaber: **SCHERING AKTIENGESELLSCHAFT Berlin und Bergkamen
Müllerstrasse 170/178 Postfach 65 03 11
D-1000 Berlin 65 (DE)**

(72) Erfinder: **Bock, Martin, Dr.
Senheimer Strasse 19
D-1000 Berlin 28 (DE)**
Erfinder: **Heymann, Kurt, Dr.
Reichsstrasse 84
D-1000 Berlin 19 (DE)**
Erfinder: **Middeke, Hermann-Josef, Dr.
Sächsische Strasse 12
D-1000 Berlin 31 (DE)**
Erfinder: **Tenbrink, Detlef
Büdnerring 42
D-1000 Berlin 51 (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Vorbehandlung von keramischen Materialien zur haftfesten chemischen Metallisierung.

Es sind Verfahren zur Metallisierung nicht leitender Gegenstände mit chemisch arbeitenden Bädern bekannt. Zur Erzielung einer hinreichenden Haftfestigkeit ist es erforderlich, die Oberflächen dieser Gegenstände mechanisch oder chemisch aufzurauhen.

Keramische Materialien, die aufgrund ihrer dielektrischen und wärmeleitenden Eigenschaften in zunehmenden Maße in der Elektrotechnik eingesetzt werden, werden üblicherweise durch Bedrukken und Einbrennen metallhaltiger Pasten oder durch Bedampfungsverfahren im Vakuum metallisiert. Die chemische Metallisierung ist ein wesentlich einfacheres Metallisierungsverfahren, setzt aber eine Aufrauhung der Oberfläche voraus. Zur Erzielung feinster Leiterbahnstrukturen, aber auch aus elektrischen Gründen, muß die Rauhtiefe möglichst gering sein, so daß eine mechanische Aufrauhung ausscheidet.

Ein chemischer Aufrauhprozeß sollte für möglichst viele verschiedene keramische Materialien geeignet sein, zum Beispiel für Aluminiumoxid, Aluminiumnitrid, Berylliumoxid, Bariumtitanat, Ferrite, Siliziumnitrid, Siliziumcarbid, Silikate, Magnesiumoxid, Zirkoniumoxid.

Ein bekanntes Verfahren zur Aufrauhung von Aluminiumoxidkeramik ist zum Beispiel die Behandlung in Schmelzen von Alkalihydroxiden. Durch Tauchen derartiger Keramikteile wird die Oberfläche von dem Alkalihydroxid angeätzt und somit aufgerauht, so daß nach geeigneter Aktivierung durch Abscheidung von Metallkeimen eine haftfeste chemische Metallisierung möglich ist.

Nachteilig bei diesem Verfahren ist die Tatsache, daß bei dem Herausziehen der Keramikteile aus der Schmelze sehr viel Alkalihydroxid verschleppt wird. Darüber hinaus ist die Gefahr der Verunreinigung der Schmelze durch eingeschleppte Fremdstoffe und abgelöste Keramikbestandteile groß. Derartige Verunreinigungen können Qualitätseinbußen bewirken.

In der DE-A1 3150339 ist ein Verfahren beschrieben, bei dem die Gegenstände aus Aluminiumoxidkeramik in einer Alkalihydroxidlösung getaucht und anschließend getrocknet und über den Schmelzpunkt des Alkalihydroxids erhitzt werden. Dieses Verfahren erlaubt zwar eine vereinfachte Prozeßführung, hat aber den Nachteil, daß die auf der Oberfläche der Keramik verbleibende Alkalihydroxidmenge für eine hinreichende und gleichmäßige Aufrauhung meistens nicht ausreicht.

Aufgabe der vorliegenden Erfindung ist daher, ein Verfahren zur Verfügung zu stellen, das in energiesparender Weise unter Vermeidung unnötiger Verschleppungsverluste eine gleichmäßige haftfeste Metallisierung auch von kompliziert geformten Körpern aus unterschiedlichen Keramikwerkstoffen ermöglicht.

Diese Aufgabe wird erfindungsgemäß durch ein Verfahren gelöst, das dadurch gekennzeichnet ist, daß auf die Keramikteile zur Aufrauhung vor der chemischen Metallisierung eine Salzlösung aufgetragen wird, deren Viskosität durch Zuschlagstoffe erhöht ist, worauf die Teile getrocknet und erhitzt werden.

Besondere Ausführungsformen des Verfahrens bestehen darin,

a) daß das gelöste Salz je nach dem zu behandelnden Material bei hoher Temperatur sauer oder alkalisch reagiert und die Keramik ätzt,

b) daß das Salz in konzentrierter, vorzugsweise gesättigter Lösung vorliegt,

c) daß das Salz ein Hydrogensulfat oder Hydrogenfluorid oder ein Alkalihydroxid oder ein Alkalicarbonat oder Borax oder Ammoniumnatriumhydrogenphosphat ist,

d) daß zur Senkung des Schmelzpunktes weitere Salze zu der Lösung gegeben werden,

e) daß die Viskosität der Salzlösung durch Zugabe von Pulvern oder von löslichen Stoffen, vorzugsweise Polymere, wie zum Beispiel Polyvinylalkohol, oder Phixotropiemitteln, wie zum Beispiel Bentonite, dickflüssig, thixotrop oder pastös eingestellt wird, oder daß das Salz in pulverisierter Form in einer gesättigten Lösung mit Bodenkörper vorliegt, wobei vorzugsweise polare organische Lösungsmittel wie Alkohole eingesetzt werden, wenn nötig mit Polymerzusatz,

f) daß die Keramikteile mit dieser Lösung durch Tauchen, Besprühen, Siebdrucken, Filmgießen, Walzenbeschichtung oder Aufschleudern behandelt werden,

g) daß die Keramikteile getrocknet werden,

h) daß die Keramik bis über den Schmelzpunkt des Salzes oder Salzgemisches erhitzt werden.

Das erfindungsgemäße Verfahren hat gegenüber den bekannten Verfahren den Vorteil, die chemische Aufrauhung unter der Vermeidung der technisch aufwendigen Alkalihydroxidschmelze zu ermöglichen und im Gegensatz zu dem in der Offenlegungsschrift 3150399 A1 beschriebenen Verfahren hinreichend viel Ätzmittel auf die Oberfläche aufzutragen, so daß eine energie- und chemikaliensparende Führung des Aufrauhprozesses möglich ist. Eine weitere Steigerung der Wirtschaftlichkeit ergibt sich aus der Einsparung von Spülwasser. Im Gegensatz zu den bekannten Technologien der Keramikmetallisierung erübrigt sich eine Reinigung oder anderweitige Vorbehandlung der Keramikoberfläche.

Das erfindungsgemäße Verfahren ist daher technisch besonders fortschrittlich und führt zu hohen Haftfestigkeiten ; so tritt beim senkrechten Abriß eines auf die Metallisierung gelöteten Prüfstempels im allgemeinen ein Kohäsionsbruch der Keramik auf.

Für oxidische Keramiken und für AlN sind sowohl die basische als auch die saure Variante der Aufrauhung geeignet, für Silikate, Siliziumcarbid und Siliziumnitrid die basische und für Bariumtitanat die saure.

Die verwendeten Salzlösungen sollen vorzugsweise gesättigt sein, können auch feindispers Bodenkörper zur Steigerung der Viskosität enthalten. Als basische Salze kommen vorzugsweise Natrium- und Kaliumhydroxid in Frage, als Pulverzusatz eignen sich vorzugsweise Alkalicarbonate oder Erdalkalihydroxide. Bei Verwendung von polaren Lösemitteln, vorzugsweise Methanol oder Ethanol dient das Alkalihydroxid selbst zur Steigerung der Viskosität. Für die saure Beizung werden vorzugsweise Natrium- oder Ammoniumhydrogensulfat oder Ammoniumhydrogenfluorid eingesetzt. Für höher wärmebalastbare Oxid- oder Nitridkeramik ist darüberhinaus der Einsatz von Borax oder Ammoniumnatriumhydrogenphosphat möglich.

Als polymeres Verdickungsmittel ist vor allem Polyvinylalkohol als Thixotropiemittel insbesondere Betonite geeignet.

Die Durchführung des erfindungsgemäßen Verfahrens erfolgt durch Tauchen, Spritzen, Gießen, Siebdrucken, Pinseln, Streichen der zu metallisierenden Gegenstände mit den erfindungsgemäß zu verwendenden Lösungen oder Pasten. Diese Behandlung kann auf der gesamten Oberfläche oder selektiv auf den zu metallisierenden Strukturen erfolgen. Die Behandlungsdauer beim Tauchen richtet sich nach der Benetzbarkeit der Materialien und beträgt etwa 10 Sekunden bis 2 Minuten.

Die anschließende Trocknung erfolgt durch Abdunsten des Lösemittels durch Erwärmen der zu metallisierenden Gegenstände. Nach dem Trocknen werden die Teile über den Schmelz- oder Zersetzungspunkt der Salze erhitzt, wobei im Falle der Alkalihydroxide eine Wasserdampfatmospäre als Schutzgas gegen vorzeitige Carbonatisierung der Schmelze und zur Beschleunigung der Ätzung dienen kann. Trocknung und Erhitzung geschehen zweckmäßigerweise in einem stationären Ofen mit entsprechend eingestellter Temperatur oder in einem Durchlaufofen oder Mehrzonen D.L.O. bei entsprechendem eingestelltem Temperaturprofil.

Die Reaktionsrückstände werden durch Spülung von den Keramikoberflächen entfernt, wobei insbesondere bei Zusätzen durch "inerte" Pulver oder Polyvinylalkohol die Anwendung von Ultraschallenergie sich als günstig erweist.

Die Aktivierung und chemische Metallisierung der erfindungsgemäß behandelten Teile wird nach bekannten Verfahren unter Verwendung der hierfür üblichen Bäder durchgeführt.

Die erfindungsgemäß metallisierten keramischen Materialien finden beispielsweise Verwendung in der Elektrotechnik als Träger für Hybride, Leistungsbauelemente, HF - Bauelemente, als keramische Halbleitergehäuse (chip carrier), keramische Kondensatoren und Filter. Die metallisierten keramischen Gegenstände können mit Hilfe von Schweiß- oder Löttechniken gefügt werden.

Die folgenden Beispiele dienen der Erläuterung der Erfindung.

Beispiel 1 :

Eine Edelstahlplatte, deren Oberfläche mit einer 200 µm dicken plasmagespritzten Aluminiumoxidschicht bedeckt ist, wird durch Bestreichen mit einer Paste aus einer gesättigten Lösung von Natriumhydroxid in Ethanol mit feingepulvertem Natriumhydroxid als reaktivem Füllstoff, Trocknen bei Raumtemperatur und Erhitzen auf 350°C während 10 Minuten durch Bildung von Natriumaluminat angeätzt. Anschließend wird die Platte mit Wasser gespült, mit einer Aktivatorlösung auf Basis von Palladium aktiviert und unter Verwendung eines chemischen Kupferbades metallisiert.

Die Haftfestigkeit der abgeschiedenen Metallschicht auf dem Aluminiumoxid ist größer als die des Aluminiumoxids auf dem Stahl.

Beispiel 2 :

Auf einem Keramikkörper aus mit Zirkoniumdioxid verstärktem Aluminiumoxid wird durch Walzenbeschichtung bei einer Temperatur von 95°C eine Lösung von 1000 g/l Kaliumhydrogensulfat in Wasser mit 200 g/l Betonitpulver aufgetragen und bei 120°C getrocknet. Nach 20-minütigem Erhitzen auf 280°C wird 5 Minuten in kaltem Wasser mit Ultraschallunterstützung gespült und wie in Beispiel 1 metallisiert.

Die Abzugskraft der Metallisierung beträgt 2 N/mm.

Beispiel 3

Eine Keramikplatte aus Aluminiumoxid wird mit einem Gemisch aus 3 Gewichtsteilen Thixotropiepaste und einem Teil Natriumhydroxid durch Siebdruck mit der gewünschten Struktur einseitig beschichtet Die Thixotropiepaste besteht aus einer 3%igen Suspension von Bentonite in Wasser.

Anschließend wird die Platte wie in Beispiel 1 getrocknet, erhitzt, aktiviert und in einem chemischen Kupferbad üblicher Zusammensetzung metallisiert.

Die Haftfestigkeit der Metallisierung beträgt 0,89 N/mm und kann durch eine Wärmebehandlung auf den hohen Wert von 1,8 N gesteigert werden.

Beispiel 4

Eine Keramikplatte wird wie in Beispiel 5 durch Erhitzen mit Natriumhydroxid und Thixotropiemittel aufgerauht und anschließend durch ein System mit Zinn IV - Zinn II - salzlösungen sensibilisiert. Die Platte wird dann in einer Palladiumchloridlösung aktiviert und in einem chemischen Nickelbad mit Hydrazin als Reduktor metallisiert. Die Haftfestigkeit beträgt 1,1 N/mm.

## Ansprüche

1. Verfahren zur Vorbehandlung von keramischen Materialien zur haftfesten chemischen Metallisierung durch Ätzen, dadurch gekennzeichnet, daß auf die Keramikteile zur Aufrauhung vor der chemischen Metallisierung eine Salzlösung aufgetragen wird, deren Viskosität durch Zuschlagstoffe erhöht ist, worauf die Teile getrocknet und erhitzt Werden.

2. Verfahren gemäß Anspruch 1 dadurch gekennzeichnet, daß das gelöste Salz je nach dem zu behandelnden Material bei hoher Temperatur sauer oder alkalisch reagiert und die Keramik ätzt.

3. Verfahren gemäß Anspruch 1, dadurch gekennzeichnet, daß das Salz in konzentrierter, vorzugsweise gesättigter Lösung vorliegt.

4. Verfahren gemäß Anspruch 1, dadurch gekennzeichnet, daß das Salz ein Hydrogensulfat oder Hydrogenfluorid oder ein Alkalihydroxid oder ein Alkalicarbonat oder Borax oder Ammoniumhydrogenphosphat ist.

5. Verfahren gemäß Anspruch 1, dadurch gekennzeichnet, daß zur Senkung des Schmelzpunktes weitere Salze zu der Lösung gegeben werden.

6. Verfahren gemäß Anspruch 1, dadurch gekennzeichnet, daß die Viskosität der Salzlösung durch Zugabe von Pulvern oder von löslichen Stoffen, vorzugsweise Polymere, wie zum Beispiel Polyvinylalkohol, oder Thixotropiemitteln, wie zum Beispiel Bentonite, dickflüssig, thixotrop oder pastös eingestellt wird, oder daß das Salz in pulverisierter Form in einer gesättigten Lösung mit Bodenkörper vorliegt, wobei vorzugsweise polare organische Lösungsmittel wie Alkohole eingesetzt werden, wenn nötig mit Polymerzusatz.

7. Verfahren gemäß Anspruch 1, dadurch gekennzeichnet daß die Keramikteile mit dieser Lösung durch Tauchen, Besprühen Siebdrucken, Filmgießen Walzenbeschichtung oder Aufschleudern behandelt werden.

8. Verfahren gemäß Anspruch 1, dadurch gekennzeichnet, daß die Keramikteile getrocknet werden.

9. Verfahren gemäß Anspruch 1, dadurch gekennzeichnet, daß die Keramik bis über den Schmelzpunkt des Salzes oder Salzgemisches erhitzt werden.

10. Leiterplatten nach Verfahren gemäß Ansprüche 1 bis 9 hergestellt.

## Claims

1. Process for pretreating ceramic materials for high-adhesion chemically-induced metal plating brought about by etching characterized in that for the purpose of roughening prior to metallic chemical plating, the ceramic parts are treated with a salt solution the viscosity of which is increased by additives, whereafter the parts are dried and heated.

2. Process in accordance with Claim 1 characterized in that the dissolved salt reacts in an acidic or alkaline manner at high temperature depending on the material to be treated and etches the ceramic material.

3. Process in accordance with Claim 1 characterized in that the salt is present in a concentrated and preferably saturated solution.

4. Process in accordance with Claim 1 characterized in that the salt is a hydrogen sulphate or hydrogen fluoride or an alkali hydroxide or an alkali carbonate or borax or ammonium hydrogen phosphate.

5. Process in accordance with Claim 1 characterized in that further salts are added to the solution to lower the melting point.

6. Process in accordance with Claim 1 characterized in that the viscosity of the salt solution is thickened, or made thixotropic or paste-like by addition of powders or of soluble substances, preferentially polymers such as, for example, polyvinyl alcohol or thixotropic agents such as, for example, bentonites, or that the salt is present in powder form in a saturated solution with a sediment in which connection preferential use is made of polar organic solvents such as alcohols, if necessary with polymer additive.

7. Process in accordance with Claim 1 characterized in that the ceramic parts are treated with this solution by immersion, spraying, screen or film application, roller coating or centrifugal application.

8. Process in accordance with Claim 1 characterized in that the ceramic parts are dried.

9. Process in accordance with Claim 1 characterized in that the ceramics are heated above the melting point of the salt or mixture of salts.

10. Circuit boards produced by a process in accordance with Claims 1 to 9.

## Revendications

1. Procédé de prétraitement de matériaux céramiques par décapage en vue de l'application chimique d'une couche métallique adhérente, caractérisé par ce qu'avant la métallisation chimique une solution saline est appliquée sur les pièces céramiques en vue de les rendre rugueuses, la viscosité de cette solution saline étant augmentée par des additifs et les pièces étant séchées et chauffées après son application.

2. Procédé suivant la revendication 1 caractérisé par ce qu'en fonction du matériau à traiter le sel dissous présente, à une température élevée, une réaction acide ou alcaline et attaque le matériau céramique.

3. Procédé suivant la revendication 1 caractérisé par ce que le sel est utilisé sous forme d'une solution concentrée ou, de préférence, saturée.

4. Procédé suivant la revendication 1 caractérisé par ce que le sel est un sulfate d'hydrogène ou un fluorure d'hydrogène ou un hydroxyde alcalin ou un carbonate alcalin ou du borax ou du biphosphate d'ammonium.

5. Procédé suivant la revendication 1 caractérisé par ce qu'en vue de l'abaissement du point de fusion d'autres sels sont ajoutés à la solution.

6. Procédé suivant la revendication 1 caractérisé par ce que la solution saline est rendue posseuse, thixotrope ou pâteuse par addition de poudres ou de substances solubles, de préférence polymères tel que l'alcool polyvinylique, ou d'agents thixotropes tels que des bentonites, ou caractérisé par ce que le sel est utilisé sous forme pulvérisée dans une solution saturée avec dépôt, des solvants organiques polaires tels que des alcools avec, si nécessaire, adjonction de polymères étant utilisés de préférence

7. Procédé suivant la revendication 1 caractérisé par ce que les pièces céramiques sont traitées avec cette solution par immersion, vaporisation, sérigraphie, coulage d'une couche mince, application par rouleau ou centrifugeur.

8. Procédé suivant la revendication 1 caractérisé par ce que les pièces céramiques sont séchées.

9. Procédé suivant la revendication 1 caractérisé par ce que le matériau céramique est chauffé au-delà du point de fusion du sel ou du mélange salin.

10. Plaquettes à circuits imprimés fabriquées suivant les revendications 1 à 9.